# EUROPÄISCHE PATENTSCHRIFT

(11) **EP 1 046 938 B1**
(45) Veröffentlichungstag und Bekanntmachung des Hinweises auf die Patenterteilung: **21.05.2008**
(21) Anmeldenummer: 00103522.9
(22) Anmeldetag: 18.02.2000
(51) Int. Cl.: G02B 6/42, G02B 6/38, H05K 7/14

(54) **Verbindungsvorrichtung**
Connection device
Dispositif de connection

(30) Priorität: 23.04.1999 DE 29907270 U
(43) Veröffentlichungstag der Anmeldung: 25.10.2000
(73) Patentinhaber: SICK AG, 79183 Waldkirch (DE)
(72) Erfinder: Damm, Hartmut, 79331 Teningen (DE); Böckel, Günter, 79183 Waldkirch (DE); Wetteborn, Hainer, 79183 Waldkirch (DE)
(74) Vertreter: Manitz, Finsterwald & Partner GbR

(56) Entgegenhaltungen:
- WO-A-97/20344
- US-A- 5 029 748
- US-A- 5 745 624
- US-A- 5 896 481
- HOROWITZ P.; HILL W.: 'The Art of Electronics', 1990, CAMBRIDGE UNIVERSITY PRESS, USA * Seiten 833,847,, Spalte 1085 *

## Beschreibung

Die vorliegende Erfindung betrifft eine Verbindungsvorrichtung für optische und/oder elektronische Bauteile, mit zumindest zwei korrespondierenden Kopplungselementen, von denen je eines an einem der zu verbindenden Bauteile anzuordnen ist und die in einer einstellbaren Relativposition zueinander fixierbar sind.

Beim Zusammenbau opto-elektronischer Systeme ist es erforderlich, deren einzelnen Bauteile mit hoher Präzision miteinander zu verbinden und sie dabei zueinander zu justieren. Als Beispiel sei die Sende-Empfangseinheit eines tastenden Laserscanners genannt, deren drei Bauelemente (Tubus, Sender, Empfänger) sehr genau zueinander justiert werden müssen, bevor sie miteinander fest verbunden werden.

Nach dem Stand der Technik werden die mechanischen Träger der einzelnen Bauelemente z. Bsp. miteinander durch Klemmschrauben vorerst lose verschraubt. Während des nachfolgenden Justagevorgangs werden die Schraubverbindungen über Federscheiben leicht vorgespannt. Die mechanischen Träger der Bauelemente können dann zum Zweck der Justage gegen die Vorspannkräfte der Federscheiben in zwei Achsen verschoben werden. Im Anschluß daran werden die Träger der Bauelemente fest verschraubt und zusätzlich mit Klebstoff gegen Dejustage gesichert.

Die Nachteile dieses Justage- und Fixiervorgangs liegen darin, dass die Vorspannung einerseits nicht zu hoch sein darf, damit ein leichtes und ruckfreies Verschieben der Teile gegeneinander noch möglich ist, andererseits aber die Vorspannung nicht zu gering gewählt werden darf, damit sich die Justage durch das anschließende Anziehen der Schraubverbindung nicht wieder verstellt. Zudem ist von Nachteil, dass die Justage in der dritten Achse, welche senkrecht auf den beiden genannten Achsen steht, nur mit hohem Aufwand zu bewerkstelligen ist.

In dem Dokument WO 97/20344 A ist eine Vorrichtung und ein Verfahren für eine Chipanordnung beschrieben, wobei hier ein auf einer Folie befestigter Chip an einem Gehäuse justiert und befestigt wird. Zu diesem Zweck befinden sich in der Folie Aussparungen, in die am Gehäuse befestige Stifte eingeführt werden. Die Aussparungen können dabei größer als der Stiftdurchmesser sein, um die Folie mit dem Chip auf der Gehäusefläche positionieren zu können. Nach dieser Positionierung wird die Folie mit dem Gehäuse verklebt.

Aus dem Dokument US 5.896.481 A ist eine Verbindungsvorrichtung bekannt, bei der zwei Bauteile dadurch justiert und fixiert werden, indem ein erstes mit einem Vorsprung ausgestattetes Bauteil in ein zweites, mit einer Nut ausgestattetes Bauteil eingeführt wird, wobei sich an der Unterseite des den Vorsprung tragenden Bauteils ein nicht ausgehärteter Kleber befindet, so dass die Bauteile entlang der Nut gegeneinander verschoben werden können, solange der Kleber noch nicht ausgehärtet ist.

Das Dokument EP 0 573 941 A1 beschreibt eine optische Faser, die mit einem Endabschnitt mit einer ringförmigen Aufnahme eines Chips verbunden werden soll. Der freie Innendurchmesser der ringförmigen Auf nahme ist dabei größer bemessen als der Außendurchmesser des Endabschnitts, so dass der Endabschnitt innerhalb der ringförmigen Aufnahme justiert werden kann. Der Endabschnitt der optischen Faser ist ferner von einer Hülse umgeben, die an ihrem der ringförmigen Aufnahme zugewandten Ende einen Flansch aufweist. Die Hülse wird nach dem Justiervorgang einerseits mit dem Endabschnitt und andererseits mit der ringförmigen Aufnahme verklebt bzw. verschweißt.

Die vorliegende Erfindung hat sich die Aufgabe gestellt, eine Verbindungsvorrichtung für optische und/oder elektronische Bauteile zu schaffen, welche auf einfache Art und Weise eine präzise Justage und Fixierung der Bauteile erlaubt. Dabei soll es insbesondere möglich sein, die Justage und Fixierung in einer Serienproduktion automatisch vorzunehmen.

Diese Aufgabe wird durch eine Verbindungsvorrichtung mit den Merkmalen des Anspruchs 1 gelöst.

Bei einer derartigen Verbindungsvorrichtung sind die Kopplungselemente mittels einer im Verarbeitungszustand fließfähigen und im Gebrauchszustand festen Masse miteinander verbunden.

Die erfindungsgemäße Verbindungsvorrichtung für optoelektronische Bauteile enthält demnach zwei korrespondierende Kopplungselemente, von denen je eines an einem der zu verbindenden Bauteile anzuordnen ist und die in einer einstellbaren Relativposition zueinander fixiert werden können. Die Einstellbarkeit der Relativposition erlaubt die Justage der Kopplungselemente - und damit der Bauteile - gegeneinander. Die Verbindungsvorrichtung ist dadurch gekennzeichnet, dass die Fixierung der Kopplungselemente aneinander durch eine im Verarbeitungszustand fließfähige und im Gebrauchszustand feste Masse (im folgenden: "Fixierungsmasse") hergestellt wird.

Der erfindungsgemäße Einsatz der Fixierungsmasse hat den Vorteil, dass auf einfache Art und Weise eine sehr präzise Justage der Bauteile erreicht wird, welche auch beim nachträglichen Fixieren erhalten bleibt. Vor der endgültigen Fixierung der Bauteile befindet sich die Fixierungsmasse in ihrem Verarbeitungszustand, d.h. sie ist fließfähig. Unter "fließfähig" ist dabei ein Zustand zu verstehen, in welchem die Masse mit geringem Kraftaufwand plastisch verformbar ist. Die Viskosität der Fixierungsmasse sollte so groß sein, dass die Masse sich zwar an ihrem Bestimmungsort verteilt, aber nicht sofort von diesem wegfließt.

Beim oder nach erfolgtem Justieren der Bauteile füllt die fließfähige Fixierungsmasse den freien Raum zwischen den Kopplungselementen aus. Wenn die Fixierungsmasse bereits während des Justagevorgangs in den Bereich der Kopplungselemente eingebracht wurde, setzt sie aufgrund ihrer Plastizität der Justage nur einen vernachlässigbar geringen Widerstand entgegen, so dass die Justage quasi kräftefrei erfolgen kann. Wenn die Fixierungsmasse erst nach dem Justagevorgang in den Bereich der Kopplungselemente eingebracht wird, kann die Justage ohnehin fast kräftefrei erfolgen.

Nach erfolgter Justage wird die Fixierungsmasse in ihren festen Gebrauchszustand überführt, d.h. sie erstarrt bzw. erhärtet. Der Raum zwischen den Kopplungselementen wird dann von einer festen Masse ausgefüllt, was zu einer stabilen formschlüssigen Verbindung zwischen den Kopplungselementen führt. Zusätzlich oder alternativ kann eine Haftverbindung bestehen, wenn zwischen der Fixierungsmasse und den Kopplungselementen Adhäsionskräfte oder sogar chemische Bindungen ausgebildet werden.

Das Erstarren bzw. Aushärten der Fixierungsmasse erfolgt ohne Krafteinwirkung von außen. Damit besteht keine Gefahr, die eingestellte Justierung durch die nachfolgende Fixierung wieder zu stören.

Die erfindungsgemäße Verbindungsvorrichtung ist kostengünstiger als die bekannten Lösungen aus dem Stand der Technik, da sie keine hochgenau bearbeiteten Montageteile voraussetzt. Weiterhin erlaubt sie eine kostengünstige automatisierte Serienproduktion, da die Montage keine hohen Krafteinwirkungen erfordert und sich daher gut maschinell durchführen läßt.

Vorzugsweise handelt es sich bei der Fixierungsmasse um ein Lot, insbesondere um Lötzinn. Dieses kann - gegebenenfalls zusammen mit Löthilfsmitteln wie z.B. Lötpaste - vor der Montage an den Kopplungselementen bevorratet sein und für die Justage geschmolzen werden. Ebenso kann das flüssige Lot aber auch von außen vor, während oder nach der Justage zugeführt werden. Das flüssige Lot verteilt sich im Raum zwischen den Kopplungselementen und stellt einen stabilen Kontakt zwischen diesen her. Nach erfolgter Justage erstarrt das Lot durch Abkühlen, also ohne jegliche Krafteinwirkung von außen. Die Justierung bleibt daher unverändert erhalten.
Die beschriebene Verwendung von Lötzinn eignet sich besonders für eine automatisierte Produktion, da sich der Übergang vom fließfähigen zum festen Zustand z.B. durch eine elektrische Heizung nach Belieben steuern läßt.

Nach einer anderen Ausführungsart der Erfindung ist die Fixierungsmasse Klebstoff. Ähnlich wie das oben genannte Lot läßt sich ein Klebstoff gut in einem automatisierten Verfahren verarbeiten. Dabei ist es bevorzugt, wenn sich der Zeitpunkt der Aushärtung des Klebstoffes von außen steuern läßt, wie z.B. bei einem strahlenhärtbaren Kleber. Vorzugsweise wird ein UV-härtbarer Kleber verwendet, so dass der Prozess des Aushärtens durch Bestrahlung mit UV-Licht initiiert und durchgeführt werden kann.

Hinsichtlich der Ausgestaltung der Kopplungselemente ist erfindungsgemäß das erste Kopplungselement stiftförmig ausgebildet, wobei das zweite Kopplungselement eine Öffnung enthält in welche das erste Kopplungselement eingeführt wird. Der Begriff "stiftförmig" ist dabei weit auszulegen und umfaßt alle Anordnungen, in denen eine hervorstehende Erhebung vorhanden ist. Diese kann im Querschnitt rund oder eckig sein und muß nicht unbedingt über die gesamte Länge eine gleichbleibende Querschnittsfläche besitzen. Wichtig ist, dass die stiftförmige Erhebung in die Öffnung im zweiten Kopplungselement eingeführt werden kann. Die Öffnung muß daher einen entsprechenden Querschnitt aufweisen, welcher die Aufnahme des stiftförmigen Elementes erlaubt. Vorzugsweise ist die Öffnung etwas größer als der Stiftquerschnitt, damit der Stift mit Spiel in der Öffnung positioniert werden kann. Nach dem Einführen des Stiftes in die Öffnung ist noch eine Veränderung der Relativposition zwischen Stift und Öffnung und damit eine Justage möglich.

Das beschriebene System von stiftförmigem Element und Öffnung ist dabei vorteilhaft, weil es sich einerseits leicht und damit kostengünstig herstellen läßt und es sich andererseits gut in einem automatisierten Verfahren montieren läßt.

Die beschriebene Ausführungsform der Kopplungselemente als stiftförmiges Element und korrespondierende Öffnung wird vorzugsweise dadurch zusätzlich verbessert, dass eine Hülse oder ein ringförmiges Element vorhanden ist, welche(s) auf das stiftförmige Element nach Durchtritt durch die Öffnung aufgesetzt werden kann. Die Öffnung ist bei dieser Anordnung als Durchgangsöffnung in einem Trägerkörper (z.B. einer Platte) ausgeführt, und das stiftförmige Element ist so lang, dass es durch die Öffnung hindurch reicht und an der Rückseite des Trägerkörpers aus der Öffnung hervorsteht. Auf dieses hervorstehende Ende des stiftförmigen Elementes kann dann die oben genannte Hülse oder das ringförmige Element aufgesetzt werden.
Hierdurch werden verschiedene Vorteile erzielt. Insbesondere wird die Öffnung rückseitig abgeschlossen und ein Austreten der (fließfähigen) Fixierungsmasse verhindert. Die notwendige Menge an Fixierungsmasse kann somit verringert werden. Weiterhin findet über die Hülse (und in geringerem Maße auch über das ringförmige Element) eine bessere Kraftübertragung zwischen stiftförmigem Element und Trägerkörper statt. Schließlich ist es auch denkbar, die Fixierungsmasse in der Hülse oder am Ring zu bevorraten, so dass sie bei der Vormontage der Bauteile nicht stört und leicht separat handhabbar ist.

In der erfindungsgemäßen Ausgestaltung der Kopplungselemente ist das erste stiftförmige Kopplungselement in einer Querrichtung zur Stiftachse biegsam und in der dazu senkrechten Querrichtung zur Stiftachse biegesteif. Die Einstufung als "biegsam" bzw. "biegesteif' ist dabei anhand der bei der Montage üblicherweise auftretenden Kräfte vorzunehmen, denen nachgegeben ("biegsam") oder nicht nachgegeben ("biegesteif") wird. Die biegsame Komponente hat den Vorteil, dass gewissen zwangsläufig auftretenden Kräften beim Erstarren bzw. Aushärten der Fixierungsmasse nachgegeben werden kann. Die Achse der Biegsamkeit wird daher vorzugsweise in Richtung dieser zu erwartenden Zwangskräfte ausgerichtet. Die Steifheit sorgt dagegen für die notwendige Stabilität der Verbindung gegen störende externe Krafteinwirkungen, die eine ungewollte Dejustage bewirken könnten.
Die zuletzt beschriebene Biegsamkeit des stiftförmigen Elementes in der einen und Steifheit in der anderen Richtung läßt sich konstruktiv z.B. dadurch erreichen, dass das Kopplungselement eine streifenförmige Basis aufweist. Der Querschnitt des stiftförmigen Elementes ist also nicht rotationssymmetrisch, sondern im Wesentlichen rechteckig, wobei das Verhältnis der Seitenlängen des Rechteckes deutlich von 1:1 1 (Quadrat) abweicht. Vorzugsweise beträgt es zwischen 1:4 und 1:20. Hierdurch wird erreicht, dass das Element in Richtung der kurzen Rechteckseite biegsam und in Richtung der langen Rechteckseite biegesteif ist. Durch die Dimensionierung des Querschnittes läßt sich die absolute Höhe und das Verhältnis von Biegsamkeit und Steifheit nach Belieben steuern. Damit das stiftförmige Element noch in die Öffnung im anderen Kopplungselement paßt, muß entweder diese Öffnung entsprechend dimensioniert sein oder das stiftförmige Element um einen passenden Aufsatz verlängert sein, wobei nur dieser Aufsatz in die Öffnung eingeführt wird.

Bei der Verwendung der beschriebenen Kopplungselemente mit einer biegsamen und einer steifen Komponente werden erfindungsgemäß jeweils zwei solcher Elemente paarweise so angeordnet, dass die Achsen der Biegsamkeit bzw. Steifheit im Wesentlichen senkrecht zueinander ausgerichtet sind. Weiterhin erfolgt die Anordnung der Kopplungselemente vorzugsweise so, dass sie sich in die Symmetrie der Bauteile einfügt. Wichtig ist eine symmetrische Lage der Kopplungselemente bezüglich der Achse, zu der die Zwangskräfte beim Erstarren bzw. Aushärten der Fixierungsmasse symmetrisch auftreten. Diese Achse ist bei optischen oder optoelektronischen Vorrichtungen bevorzugt deren optische Achse. Die Zwangskräfte werden dann in die Kopplungselemente eingeleitet und heben sich aufgrund der Symmetrie in ihrer Summenwirkung nach außen hin auf.

Vorzugsweise ist die Öffnung im zweiten Kopplungselement von einer elektrischen Heizung umgeben. Durch Anlegen einer Spannung und den daraus resultierenden Stromfluß durch die Heizung kann die sich in der Öffnung befindliche Fixierungsmasse gezielt erwärmt werden, um den Übergang vom fließfähigen Verarbeitungszustand zum festen Gebrauchszustand oder umgekehrt zu steuern. Z.B. kann durch Erwärmung Lötzinn geschmolzen oder Kleber ausgehärtet werden. Die erfindungsgemäße Anordnung einer elektrischen Heizung hat dabei den Vorteil, dass die Wärme unmittelbar am Einsatzort erzeugt wird, was energieeffizient ist und umliegende Bauteile vor Beschädigungen schützt. Weiterhin lassen sich Zeitpunkt und Ausmaß der Aufheizung sehr genau steuern, und jegliche äußere Krafteinwirkungen auf die Verbindungsvorrichtung werden vermieden.

Weitere vorteilhafte Ausgestaltungen der Erfindung sind in den Unteransprüchen beschrieben.

Im Folgenden wird die Erfindung anhand der Figuren beispielhaft erläutert; in diesen zeigen:
- Fig. 1: die Sende-Empfangseinheit eines Laserscanners,
- Fig. 2: die Verbindungsvorrichtung im Querschnitt,
- Fig. 3: die Verbindungsvorrichtung mit Hülse im Querschnitt,
- Fig. 4: eine Aufsicht auf eine Verbindungsvorrichtung mit vier Stiften, und
- Fig. 5: eine Seitenansicht eines Stiftes nach Figur 4.

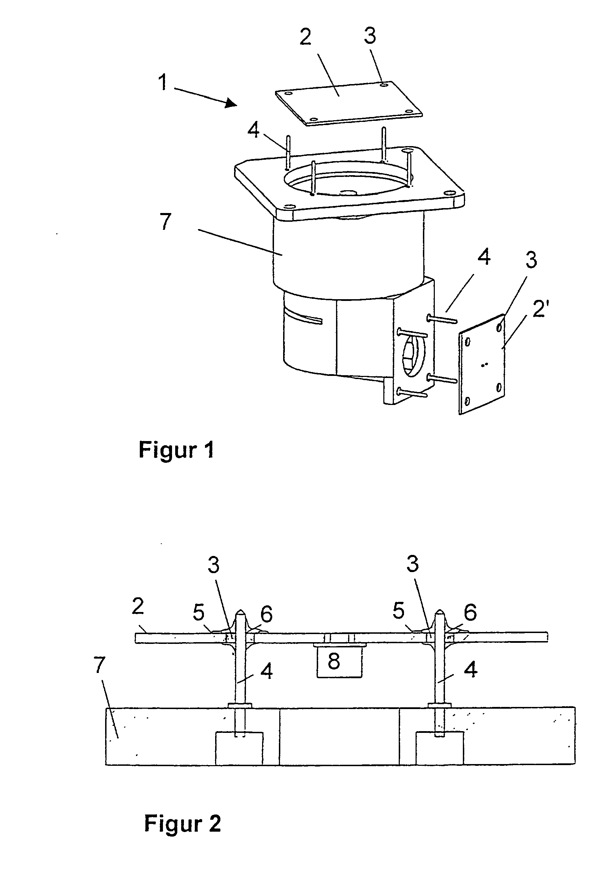

In Figur 1 ist als beispielhaftes optoelektronisches Bauteil die Sende-Empfangseinheit eines tastenden Laserscanners perspektivisch dargestellt. Sie besteht aus dem Tubus 7 mit eingebauter Sende- und Empfängerlinse, dem Sender 2', sowie dem Empfänger 2.
Der Sender 2' und der Empfänger 2 müssen mit dem Tubus 7 fest verbunden werden, wobei allerdings zuvor eine präzise Justage erfolgen muß. Die Verbindung geschieht dabei mit Hilfe der erfindungsgemäßen Verbindungsvorrichtung 1, welche im dargestellten Fall als integraler Bestandteil des Tubus 7 und des Senders 2' bzw. Empfängers 2 ausgebildet ist.

Dabei sind am Tubus 7 (pro Verbindungsvorrichtung) vier stiftförmige Elemente 4 an den Ecken eines Quadrates senkrecht von der Oberfläche des Tubus abstehend angeordnet. Mit diesen Stiften 4 korrespondieren die Öffnungen 3 im Sender 2' bzw. Empfänger 2.
Der Sender 2' und der Empfänger 2 sind auf einer plattenförmigen Keramik aufgebaut. Auf dieser befindet sich eine Sende- bzw. Empfängerdiode 8. Außerdem weist die Keramik neben der eigentlichen Ansteuerelektronik die Bohrungen 3 auf, welche die Öffnungen für die Verbindungsvorrichtung 1 bilden.

In Figur 2 ist ein Querschnitt durch die Verbindungsvorrichtung 1 dargestellt, auf dem zwei stiftförmige Elemente 4 zu erkennen sind, die durch zwei korrespondierende Öffnungen 3 des Empfängers 2 ragen. Als wesentliches Element der Verbindungsvorrichtung ist dabei ferner die Fixierungsmasse 6 erkennbar, welche den Freiraum zwischen jeweils einem Stift 4 und der Öffnung 3 ausfüllt und für die Fixierung des Empfängers 2 am Tubus 7 sorgt. Im dargestellten Fall besteht die Fixierungsmasse 6 aus Lötzinn.

### Die Montage der Verbindungsvorrichtung verläuft wie folgt:

Um die Bohrungen 3 herum sind Heizwiderstände 5 aufgedruckt. Zur Montage wird die Baugruppe 2 auf die Stifte 4 des Tubus 7 gesteckt und automatisiert in allen drei orthogonalen Achsen ohne Einwirkung von Gegenkräften justiert. Von Vorteil ist hierbei die Anzahl der justierbaren Achsen. Es ist möglich, in allen drei orthogonalen Achsen und in den drei Rotationsachsen zu justieren. Zur Fixierung wird dann für einige Sekunden eine elektrische Spannung an die aufgedruckten Heizwiderstände 5 angelegt, was zum Schmelzen des nun zugeführte Lötzinns 6 bzw. der sich bereits in den Bohrungen 3 befindlichen Lötpaste führt und die Baugruppe 2 nach Erhärtung des Lots kräftefrei fixiert.
Zur kräftefreien Fixierung der Baugruppen 2 bzw. 2' kann alternativ zu dem beschriebenen Lötverfahren auch UV-härtender Klebstoff verwendet werden. In diesem Fall wird anstelle des Anlegens einer elektrischen Spannung an Heizwiderstände die justierte Anordnung mit UV-Licht bestrahlt, und der in die Bohrungen eingebrachte UV-Kleber ausgehärtet.

Die beschriebene Vorgehensweise erfolgt sowohl bei der Justage und Fixierung der Senderbaugruppe 2' wie auch bei der Empfängerbaugruppe 2.

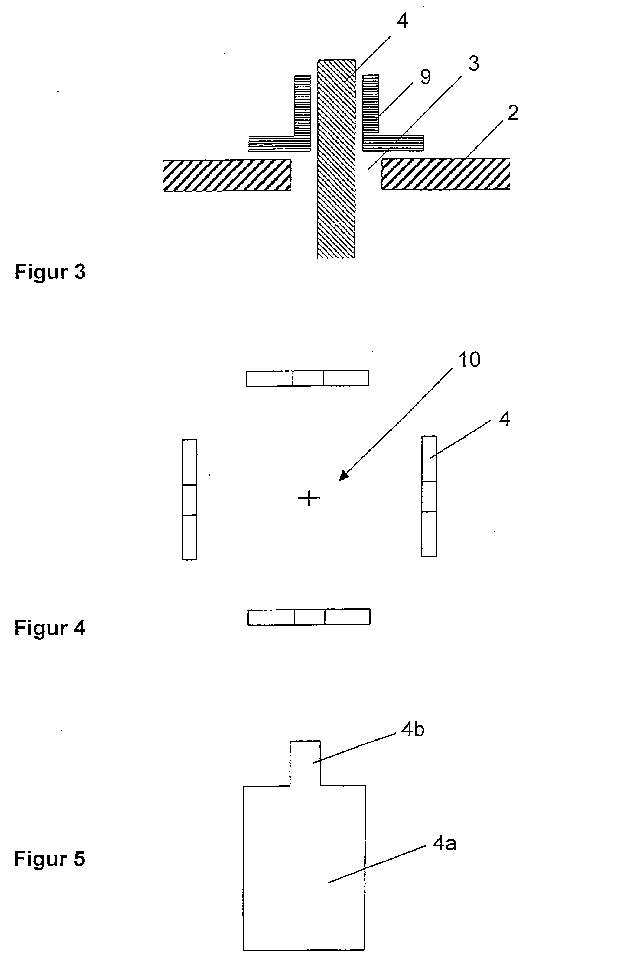

Eine bevorzugte Variante der Verbindungsvorrichtung ist in Figur 3 schematisch dargestellt. Zu erkennen ist hierbei die Platte der Baugruppe 2, durch deren Öffnung 3 der Stift 4 ragt. Auf das Ende des Stiftes 4 ist eine Hülse 9 aufgeschoben. Dadurch wird zum einen erreicht, dass weniger Lot zum Einsatz gelangt, und dass zum anderen der Vorteil einer besseren Kraftübertragung zwischen Stift 4 und Keramikplatte 2 erzielt wird. Alternativ zur Hülse 4 kann auch ein ringförmiges Element zum Einsatz gelangen, wobei dann allerdings der letztgenannte Vorteil nicht oder weniger ausgeprägt erreichbar ist.
Bei der Verwendung von zylindrischen Stiften kann sich der Nachteil ergeben, dass sich die Keramik beim Abkühlen zusammenzieht, so dass sich die Stifte verbiegen. Dies führt zu Biegespannungen in der Keramik, was schließlich ein Brechen der Keramik bewirken kann.
Diesem potentiellen Problem begegnet man in einer Anordnung, die in Figur 4 in der Aufsicht dargestellt ist. Dabei sind die Stifte 4 biegsam ausgebildet und symmetrisch um die optische Achse 10 angeordnet. Die Biegsamkeit vermeidet Biegespannungen in der Keramik, und die symmetrische Anordnung bewirkt, dass keine Dejustage beim Abkühlen auftritt. Die auf die Stifte 4 wirkenden Kräfte heben sich nämlich aufgrund der Symmetrie paarweise auf.

Damit die Biegsamkeit der Stifte 4 nicht dazu führt, dass bei der Handhabung der montierten Einheit eine Dejustage durch ein manuelles Verbiegen der Stifte auftritt, haben die Stifte die in Figur 5 in der Seitenansicht dargestellte Form. Sie bestehen demnach aus einer Basis 4a in Form eines flachen Quaders ("Streifenform"), auf welcher der Aufsatz 4b angeordnet ist, der durch die Öffnungen 3 paßt. Die flache Streifenform der Basis 4a führt dazu, dass das Element 4 quer zur großen Seitenfläche der Basis biegbar ist, während es sich parallel zur Seitenfläche steif verhält. In der symmetrischen Anordnung nach Figur 4 hat dies den Effekt, dass sich die gegenüberliegenden Elemente 4 einzeln aufeinander zu (oder voneinander weg) biegen können, wenn beim Abkühlen der Fixierungsmasse entsprechende Kräfte auftreten. Die Anordnung als Ganzes kann jedoch nicht verbogen werden, da hierzu zwangsläufig auch ein Verbiegen der jeweils querstehenden Elemente erforderlich wäre, die in dieser Richtung jedoch biegesteif sind.

Mit der erfindungsgemäßen Verbindungsvorrichtung kann somit eine Sender-Empfängereinheit automatisch justiert werden, ohne Kräfte von außen auf die Einheit einwirken zu lassen. Nach dem Fixieren des Senders oder des Empfängers tritt keine Dejustage auf.

### Bezugszeichenliste:

- 1: Verbindungsvorrichtung
- 2: Empfänger
- 2': Sender
- 3: Öffnungen
- 4, 4a, 4b: Stift
- 5: Heizung
- 6: Lötzinn
- 7: Tubus
- 8: Leuchtdiode
- 9: Hülse
- 10: Optische Achse

## Patentansprüche

1. Verbindungsvorrichtung (1) für optische und/oder elektronische Bauteile (2, 2', 7), mit zumindest zwei korrespondierenden Kopplungselementen (3, 4), von denen je eines an einem der zu verbindenden Bauteile anzuordnen ist und die in einer einstellbaren Relativposition zueinander fixierbar und mittels einer im Verarbeitungszustand fließfähigen und im Gebrauchszustand festen Masse (6) miteinander verbunden sind, wobei
- das eine Kopplungselement (4) stiftförmig ausgestaltet ist und das korrespondierende Kopplungselement (3) eine Öffnung enthält, in welche das stiftförmige Kopplungselement (4) einführbar ist,
- das stiftförmige Kopplungselement (4) in einer Querrichtung zur Stiftachse biegsam und in der dazu senkrechten Querrichtung zur Stiftachse biegesteif ist, und
- die Verbindungsvorrichtung (1) mindestens zwei, insbesondere vier stiftförmige Kopplungselemente (4) enthält, deren Achsen der Biegsamkeit bzw. Biegesteifheit zumindest im Wesentlichen senkrecht zueinander ausgerichtet sind.

2. Verbindungsvorrichtung nach Anspruch 1,
**dadurch gekennzeichnet,**
**dass** die Masse (6) ein Lot ist, vorzugsweise Lötzinn.

3. Verbindungsvorrichtung nach einem der Ansprüche 1 oder 2,
**dadurch gekennzeichnet,**
**dass** die Masse ein Klebstoff ist, vorzugsweise ein strahlenhärtbarer Klebstoff.

4. Verbindungsvorrichtung nach einem der vorhergehenden Ansprüche,
**dadurch gekennzeichnet,**
**dass** sie eine Hülse (9) oder ein ringförmiges Element aufweist, welche(s) auf das stiftförmige Kopplungselement (4) aufsetzbar ist und dabei den Randbereich der Öffnung im korrespondierenden Kopplungselement (3) berührt.

5. Verbindungsvorrichtung nach einem der vorhergehenden Ansprüche,
**dadurch gekennzeichnet,**
**dass** das stiftförmige Kopplungselement (4) eine streifenförmige Basis (4a) aufweist.

6. Verbindungsvorrichtung nach einem der vorhergehenden Ansprüche,
**dadurch gekennzeichnet,**
**dass** sie vier stiftförmige Kopplungselemente (4) enthält, deren Achsen der Biegsamkeit bzw. Biegesteifheit zumindest im wesentlichen senkrecht zueinander ausgerichtet sind.

7. Verbindungsvorrichtung nach einem der vorhergehenden Ansprüche,
**dadurch gekennzeichnet,**
**dass** die Öffnung im Kopplungselement (3) von einem elektrisch beheizbaren Element (5) umgeben ist.

8. Verbindungsvorrichtung nach einem der vorhergehenden Ansprüche,
**dadurch gekennzeichnet,**
**dass** zur Kopplung zweier Bauteile zwei oder mehrere stiftförmige Kopplungselemente (4) und eine entsprechende Anzahl von Öffnungen (3) im korrespondierenden Kopplungselement (3) vorgesehen sind.

9. Optoelektronisches Bauteil, vorzugsweise Sende- und/oder Empfängereinheit,
**dadurch gekennzeichnet,**
**dass** es zumindest eine Verbindungsvorrichtung (1) nach einem der Ansprüche 1 bis 8 enthält.

10. Optoelektronisches Bauteil nach Anspruch 9,
**dadurch gekennzeichnet,**
**dass** die Verbindungsvorrichtung (1) integraler Bestandteil des Bauteiles ist.

## Claims

1. A connection device (1) for optical and/or electronic components (2, 2', 7), having at least two corresponding coupling elements (3, 4) of which a respective one is to be arranged at one of the components to be connected and which can be fixed in an adjustable relative position to one another and which are connected to one another by means of a mass (6) which is flowable in the processing state and solid in the state of use, wherein
- the one coupling element (4) is designed in pin form and the corresponding coupling element (3) has an opening into which the pin-shaped coupling (4) can be introduced;
- the pin-shaped coupling element (4) is flexible in a direction transverse to the pin axis and is stiff in bending in the direction perpendicular thereto and transverse to the pin axis; and
- the connection device (1) includes at least two pin-shaped coupling elements (4), in particular four pin-shaped coupling elements, whose axes of flexibility or bending stiffness are aligned at least substantially perpendicular to one another.

2. A connection device in accordance with claim 1, **characterised in that** the mass (6) is a solder, preferably tin solder.

3. A connection device in accordance with one of the claims 1 or 2, **characterised in that** the mass is an adhesive, preferably a radiation curable adhesive.

4. A connection device in accordance with any one of the preceding claims, **characterised in that** it has a sleeve (9) or a ring-shaped element which can be placed onto the pin-shaped coupling element (4) and which in doing so contacts the marginal region of the opening in the corresponding coupling element (3).

5. A connection device in accordance with any one of the preceding claims, **characterised in that** the pin-shaped coupling element (4) has a strip-shaped base (4a).

6. A connection device in accordance with any one of the preceding claims, **characterised in that** it includes four pin-shaped coupling elements (4) whose axes of flexibility or flexural resistance are aligned at least substantially perpendicular to one another.

7. A connection device in accordance with any one of the preceding claims, **characterised in that** the opening in the coupling element (3) is surrounded by an electrically heatable element (5).

8. A connection device in accordance with any one of the preceding claims, **characterised in that** two or more pin-shaped coupling elements (4) and a corresponding number of openings (3) are provided in the corresponding coupling element (3) for the coupling of two components.

9. An optoelectronic component, preferably a transmitter and/or receiver unit, **characterised in that** it includes at least one connection device (1) in accordance with any one of the claims 1 to 8.

10. An optoelectronic component in accordance with claim 9, **characterised in that** the connection device (1) is an integral part of the component.

## Revendications

1. Dispositif de connexion (1) pour composants optiques et/ou électroniques (2, 2', 7), comprenant au moins deux éléments de couplage correspondants (3, 4) qu'il s'agit d'agencer respectivement sur l'un des composants à connecter, et qui peuvent être fixés dans une position relative réglable l'un par rapport à l'autre et être reliés l'un à l'autre au moyen d'une masse (6) qui s'écoule dans l'état de préparation et qui est solide dans l'état d'utilisation, dans lequel
- l'un des éléments de couplage (4) est réalisé en forme de tige et l'élément de couplage correspondant (3) contient une ouverture dans laquelle l'élément de couplage (4) en forme de tige peut être introduit,
- l'élément de couplage (4) en forme de tige est flexible dans une direction transversale à l'axe de la tige et rigide vis-à-vis de la flexion dans la direction transversale à l'axe de la tige, perpendiculaire à cette dernière, et
- le dispositif de connexion (1) contient au moins deux, et en particulier quatre, éléments de couplage (4) en forme de tige, dont les axes définissant la flexibilité ou respectivement la rigidité vis-à-vis de la flexion sont orientés au moins sensiblement perpendiculairement l'un à l'autre.

2. Dispositif de connexion selon la revendication 1,
**caractérisé en ce que** la masse (6) est un apport de brasage, de préférence à base de zinc.

3. Dispositif de connexion selon l'une des revendications 1 ou 2,
**caractérisé en ce que** la masse est une colle, de préférence une colle durcissable par application de rayonnement.

4. Dispositif de connexion selon l'une des revendications précédentes,
**caractérisé en ce qu'**il comprend une douille (9) ou un élément de forme annulaire, qui peut être posé(e) sur l'élément de couplage (4) en forme de tige et qui touche ici la région de bordure de l'ouverture dans l'élément de couplage (3) correspondant.

5. Dispositif de connexion selon l'une des revendications précédentes,
**caractérisé en ce que** l'élément de couplage (4) en forme de tige comprend une base (4a) en forme de ruban.

6. Dispositif de connexion selon l'une des revendications précédentes,
**caractérisé en ce qu'**il contient quatre éléments de couplage (4) en forme de tige dont les axes définissant la flexibilité ou respectivement la rigidité en flexion sont orientés au moins sensiblement perpendiculairement l'un à l'autre.

7. Dispositif de connexion selon l'une des revendications précédentes,
**caractérisé en ce que** l'ouverture dans l'élément de couplage (3) est entourée par un élément (5) à chauffage électrique.

8. Dispositif de connexion selon l'une des revendications précédentes,
**caractérisé en ce que** pour le couplage de deux composants, il est prévu deux ou plusieurs éléments de couplage (4) en forme de tige et un nombre correspondant d'ouvertures (3) dans l'élément de couplage correspondant (3).

9. Composant optoélectronique, de préférence unité émettrice et/ou réceptrice,
**caractérisé en ce qu'**il contient au moins un dispositif de connexion (1) selon l'une des revendications 1 à 8.

10. Composant optoélectronique selon la revendication 9,
**caractérisé en ce que** le dispositif de connexion (1) est un composant intégral du composant.
